# EUROPEAN PATENT APPLICATION

(11) **EP 4 642 185 A1**
(43) Date of publication of application: **29.10.2025**
(21) Application number: 25162982.0
(22) Date of filing: 11.03.2025
(51) Int. Cl.: H10B 43/30, H10D 30/01, H10D 30/67, H10D 30/69, H10D 64/01

(54) **OXIDE SEMICONDUCTOR MEMORY DEVICE WITH DUAL CHANNEL STRUCTURE AND MANUFACTURING METHOD THEREOF**

(30) Priority: 15.03.2024 KR 20240036431; 03.09.2024 KR 20240119159
(71) Applicant: Korea Advanced Institute of Science and Technology, Daejeon 34141 (KR)
(72) Inventor: CHO, Byung Jin, 34141 Daejeon (KR); PARK, YoungKeun, 34141 Daejeon (KR); JEONG, Jaejoong, 34141 Daejeon (KR); KANG, Daehyun, 34141 Daejeon (KR); KIM, Sheunghun, 34141 Daejeon (KR); CHU, Jun Hong, 34141 Daejeon (KR)
(74) Representative: Mathys & Squire

(57) **Abstract**

The present invention relates to an oxide semiconductor memory device with a dual channel structure and a manufacturing method thereof, and more particularly, to an oxide semiconductor memory device with a dual channel structure including a polysilicon channel in addition to an oxide semiconductor channel, and a manufacturing method thereof. The present invention is to achieve high mobility characteristics of an oxide semiconductor channel and simultaneously implement an erase operation by using an oxide semiconductor channel and a polysilicon channel together.

## Description

### CROSS-REFERENCE TO RELATED APPLICATIONS

This application claims priority under 35 U.S.C. §119 to Korean Patent Application No. 10-2024-0036431, filed on March 15th, 2024, and No. 10-2024-0119159, filed on September 3rd, 2024, in the Korean Intellectual Property Office, the disclosure of which is incorporated herein by reference in its entirety.

### TECHNICAL FIELD

The following disclosure relates to an oxide semiconductor memory device with a dual channel structure and a manufacturing method thereof, and more particularly, to an oxide semiconductor memory device with a dual channel structure including a polysilicon channel in addition to an oxide semiconductor channel, and a manufacturing method thereof.

### BACKGROUND

Currently, the demand for memory semiconductors is increasing explosively due to the 4th industrial revolution. As Internet-on-Things (IoT) devices are increasing explosively, the demand for memory is increasing in an edge device including a smartphone, and the amount of data that should be handled is increasing explosively as deep learning is utilized.

In order to keep up with this technological trend, nonvolatile memory semiconductors require high integration and excellent memory performance, and 3D NAND flash memory is leading the nonvolatile memory market because it is far superior to other methods in terms of device integration.

The 3D NAND flash memory is not only playing the role of nonvolatile memory, but is also attracting attention as a computing-in-memory (CIM) device for the upcoming AI era. The CIM device are devices that perform a multiply and accumulation (MAC) operation, a core operation of deep learning, at the memory level, and may operate more efficiently because frequent data transfer between logic and memory is reduced.

In the latest trend of the devices that cause the memory to perform the operation, it is more essential than ever to perform read, write, and erase operations of the memory as quickly as possible and store a large amount of information (e.g., 3 bits/cell) in a single device.

Meanwhile, research on oxide semiconductors to replace silicon-based semiconductor devices is being widely conducted to improve the performance of the 3D NAND flash memory. In terms of materials, research results on single, binary, and ternary compounds based on indium oxide (In₂O₃), zinc oxide (ZnO), gallium oxide (Ga₂O₃), indium zinc oxide (InZnO), zinc tin oxide (ZTO), and indium gallium zinc oxide (InGaZnO) are being reported. The oxide semiconductors have the advantage of superior mobility compared to hydrogenated amorphous silicon.

However, the oxide semiconductors have a problem in that the wider energy band gap characteristics compared to the polycrystalline silicon channels and a Fermi level pinning phenomenon caused by specific defects may restrict the generation of hole current for erase operations. In other words, the oxide semiconductors have problems in that the erase operation is limited despite their excellent program operations.

### SUMMARY

An embodiment of the present disclosure is directed to providing high mobility characteristics of an oxide semiconductor channel and simultaneously implementing an erase operation by using an oxide semiconductor channel and a polysilicon channel together.

In one general aspect, an oxide semiconductor memory device with dual channel structure includes a dual channel that includes a plurality of channels, a tunnel layer that is located on the dual channel, a charge trap layer that is located on the tunnel layer and traps an injected charge, a blocking layer that is located on the charge trap layer, and a gate electrode that is located on the blocking layer and applied with an on voltage and an off voltage from a gate bias circuit.

The dual channel may include an oxide semiconductor channel and a polysilicon channel.

The polysilicon channel of the dual channel may be formed between the oxide semiconductor channel and the tunnel layer.

The polysilicon channel may have a thickness of 2 nm or less and 1 nm or more.

The oxide semiconductor channel may include at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO).

In another general aspect, a manufacturing method of an oxide semiconductor memory device with dual channel structure includes (a) alternately laminating a word line and an inter layer dielectric, (b) forming a cylindrical hole in a center of the laminated word line and inter layer dielectric and forming a blocking layer on an inner circumferential surface of the hole, (c) forming a charge trap layer on an inner circumferential surface of the blocking layer, (d) forming a tunnel layer on an inner circumferential surface of the charge trap layer, (e) forming a polysilicon channel on an inner circumferential surface of the tunnel layer, (f) forming an oxide semiconductor channel on an inner circumferential surface of the polysilicon channel, and (g) forming a gate electrode by removing the inter layer dielectric and depositing a metal along the word line.

In the step (e), the polysilicon channel may be deposited using an oxidation process and a selective wet etch process.

The polysilicon channel may have a thickness of 2 nm or less and 1 nm or more.

The oxide semiconductor channel may include at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO).

### BRIEF DESCRIPTION OF THE DRAWINGS

FIG. 1 is a configuration diagram illustrating a configuration of an oxide semiconductor memory device with a dual channel structure according to an embodiment of the present invention.
FIG. 2 is a graph showing program operation characteristics of the oxide semiconductor memory device with a dual channel structure according to an embodiment of the present invention.
FIG. 3 is a graph illustrating erase operation characteristics of the oxide semiconductor memory device with a dual channel structure according to an embodiment of the present invention.
FIG. 4 is a graph showing the program operation and erase operation characteristics of the oxide semiconductor memory device with a dual channel structure according to an embodiment of the present invention.
FIG. 5 is a graph showing a quantum mechanical effect of the oxide semiconductor memory device with a dual channel structure according to an embodiment of the present invention.
FIG. 6 is a flowchart illustrating a manufacturing method of an oxide semiconductor memory device with a dual channel structure according to an embodiment of the present invention.

### [Detailed Description of Main Elements]

- 100:: Dual channel
- 110:: Oxide semiconductor channel
- 120:: Polysilicon channel
- 200:: Tunnel layer
- 300:: Charge trap layer
- 400:: Blocking layer
- 500:: Gate electrode

### DETAILED DESCRIPTION OF EMBODIMENTS

The above-described objects, features, and advantages of the present disclosure will become more obvious from the following detailed description provided in relation to the accompanying drawings. The following specific structural or functional descriptions are only exemplified for the purpose of describing the embodiments according to the concept of the present invention, and the embodiments according to the concept of the present invention may be implemented in various forms and should not be construed as limited to the embodiments described herein or in the application. Since embodiments of the concept of the present disclosure may be variously modified and may have several forms, specific embodiments will be illustrated in the accompanying drawings and will be described in detail in the present specification or application. However, it is to be understood that the present disclosure is not limited to specific embodiments, but includes all modifications, equivalents, and substitutions falling in the spirit and the scope of the present disclosure. Terms such as 'first', 'second', or the like, may be used to describe various components, but these components are not to be construed as being limited to these terms. The terms are used only to distinguish one component from another component. For example, a first component may be named a second component and the second component may also be named the first component, without departing from the scope of the present invention. It is to be understood that when one component is referred to as being "connected to" or "coupled to" another component, it may be connected directly to or coupled directly to another component or be connected to or coupled to another component with the other component interposed therebetween. On the other hand, it is to be understood that when one component is referred to as being "connected directly to" or "coupled directly to" another component, it may be connected to or coupled to another component without the other component interposed therebetween. Other expressions for describing the relationship between components, such as between and immediately between or adjacent to and directly adjacent to, etc., should be interpreted similarly. Terms used in the present specification are used only in order to describe specific embodiments rather than limiting the present disclosure. Singular forms include plural forms unless the context clearly indicates otherwise. It is to be understood that terms "include," "have," or the like, used in the present specification specify the presence of features, numerals, steps, operations, components, parts, or a combination thereof described in the present specification, but do not preclude the presence or addition of one or more other features, numerals, steps, operations, components, parts, or a combination thereof. Unless indicated otherwise, it is to be understood that all the terms used in the specification including technical and scientific terms have the same meaning as those that are generally understood by those who skilled in the art. Terms generally used and defined in a dictionary are to be interpreted as the same meanings with meanings within the context of the related art, and are not to be interpreted as ideal or excessively formal meanings unless clearly indicated in the present specification. Hereinafter, exemplary embodiments of the present invention will be described in detail with reference to the accompanying drawings. The same reference numerals in each drawing denote the same components.

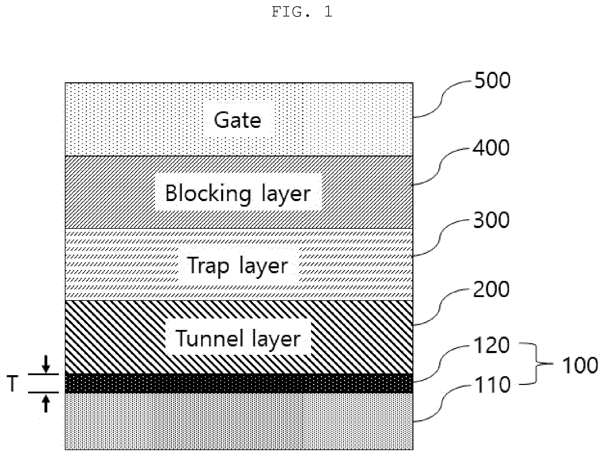

FIG. 1 is a configuration diagram illustrating a configuration of an oxide semiconductor memory device with a dual channel structure according to an embodiment of the present invention.

Referring to FIG. 1, an oxide semiconductor memory device with a dual channel structure according to an embodiment of the present invention may include a dual channel 100 that includes a polysilicon channel 120 and an oxide semiconductor channel 110, a tunnel layer 200 that is located on the dual channel 100, a charge trap layer 300 that is located on the tunnel layer 200 and traps an injected charge, a blocking layer 400 that is located on the charge trap layer 300, and a gate electrode 500 that is located on the blocking layer 400 and applied with an on voltage and an off voltage from a gate bias circuit.

The dual channel 100 may include the polysilicon channel 120 and the oxide semiconductor channel 110. The oxide semiconductor channel 110 may include at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO). The oxide semiconductor channel 110 has characteristics of high electron mobility. The dual channel 100 may include the polysilicon channel 120 between the oxide semiconductor channel 110 and the tunnel layer 200. In this case, a thickness T of the polysilicon channel 120 may be 2 nm or less and 1 nm or more. The thickness T of the polysilicon channel 120 is such that the conduction path, that is, electrons are formed in the oxide semiconductor channel 110, and when the thickness T of the polysilicon channel 120 is formed to be 2 nm or less, the conduction path is formed in the oxide semiconductor channel 110 by a quantum mechanical effect, so the electron mobility improvement effect of the oxide semiconductor channel 110 may be used as it is.

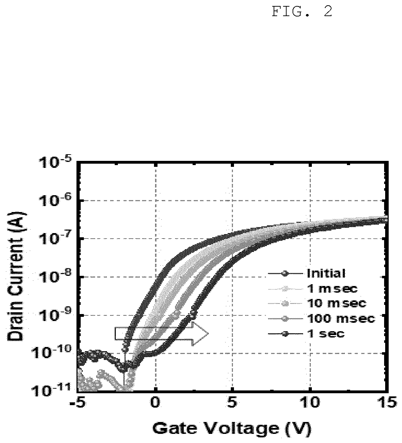

FIGS. 2 to 4 are graphs showing a program operation and erase operation characteristics of the oxide semiconductor memory device with a dual channel structure according to an embodiment of the present invention.

First, referring to FIG. 2, it can be confirmed that the threshold voltage of the oxide semiconductor memory device with a dual channel structure according to the present invention is improved to a positive value during the program operation in which a positive voltage is applied, similar to the conventional oxide semiconductor memory device.

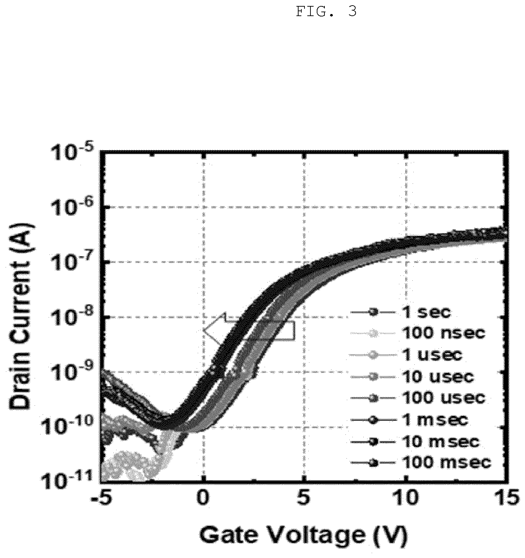

On the other hand, referring to FIG. 3, it can be confirmed that the threshold voltage of the oxide semiconductor memory device with a dual channel structure according to the present invention moves to a negative direction during the erase operation in which a negative voltage is applied, differently from the conventional oxide semiconductor memory device. The conventional oxide semiconductor memory device has a problem in that the wider energy band gap characteristics compared to the polycrystalline silicon channels and a Fermi level pinning phenomenon caused by specific defects may restrict the generation of hole current for erase operations. The oxide semiconductor memory device with dual channel structure according to the present invention may overcome the disadvantages of the conventional oxide semiconductor memory devices by adding the polysilicon channel 120 to the oxide semiconductor channel 110.

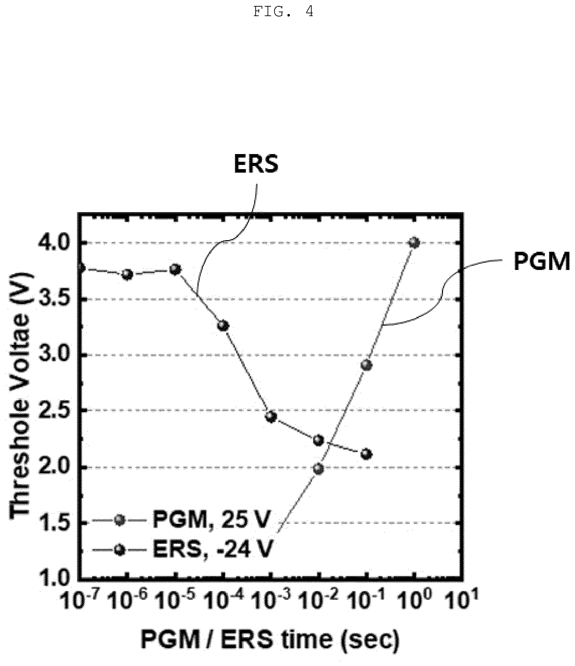

Referring to FIG. 4, the threshold voltages of the program and erase operations of the oxide semiconductor memory device with dual channel structure according to the present invention are shown over time. Referring to FIG. 4, the oxide semiconductor memory device with dual channel structure according to the present invention may confirm a normal operation in which the threshold voltage increases in the positive direction during the program operation and decreases in the negative direction during the erase operation.

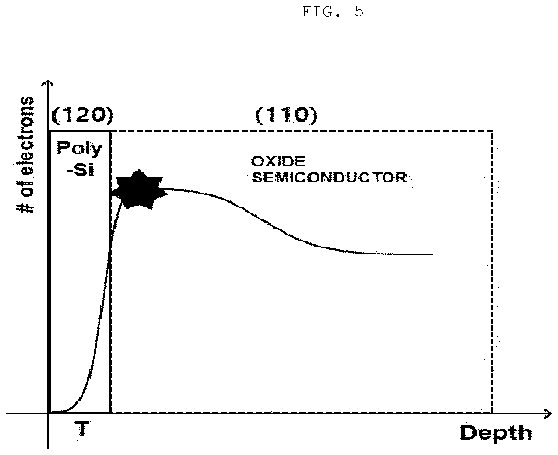

FIG. 5 is a graph showing a quantum mechanical effect of the oxide semiconductor memory device with a dual channel structure according to an embodiment of the present invention.

Referring to FIG. 5, the number of electrons (# of electrons) is located at the maximum in the oxide semiconductor channel 110, and at this time, the thickness T of the polysilicon channel 120 may be 2 nm or less. That is, the thickness T of the polysilicon channel 120 is such that the conduction path is formed in the oxide semiconductor channel 110, and when the thickness T of the polysilicon channel 120 is formed to be 2 nm or less, the conduction path is formed in the oxide semiconductor channel 110 by a quantum mechanical effect, so the electron mobility improvement effect of the oxide semiconductor channel 110 may be used as it is.

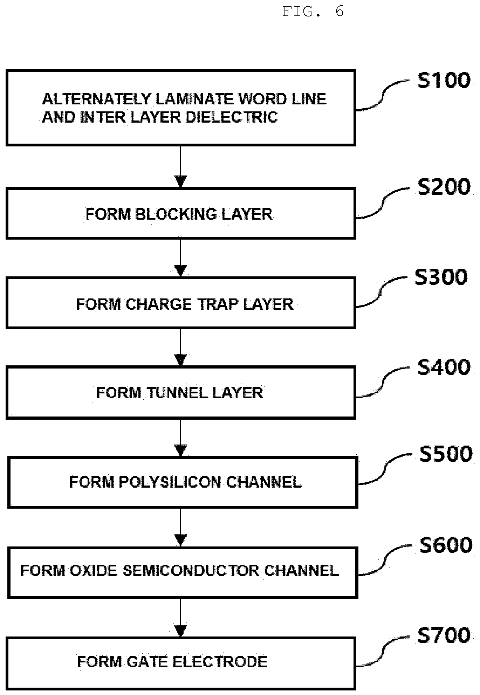

FIG. 6 is a flowchart illustrating a manufacturing method of an oxide semiconductor memory device with a dual channel structure according to an embodiment of the present invention.

Referring to FIG. 6, a manufacturing method of an oxide semiconductor memory device with dual channel structure according to an embodiment of the present invention includes (a) alternately laminating a word line WL and an inter layer dielectric ILD (S100), (b) forming a cylindrical hole in the laminated word line WL and the inter layer dielectric ILD and forming the blocking layer 400 on an inner circumferential surface of the hole (S200), (c) forming the charge trap layer 300 on an inner circumferential surface of the blocking layer 400 (S300), (d) forming the tunnel layer 200 on an inner circumferential surface of the charge trap layer 300 (S400), (e) forming the polysilicon channel 120 on an inner circumferential surface of the tunnel layer 200 (S500), (f) forming the oxide semiconductor channel on an inner circumferential surface of the polysilicon channel 120 (S600), and (g) forming the gate electrode 500 by removing the inter layer dielectric ILD and depositing a metal along the word line WL (S700).

Here, steps S100 to S400 and step S700 may follow a general 3D flash memory device process.

In step S500, the manufacturing method of an oxide semiconductor memory device with a dual channel structure according to the present invention may deposit the polysilicon channel 120 using the oxidation process and the selective wet etch process. A low-pressure chemical vapor deposition (LPCVD) method, which is a general polysilicon channel deposition method, cannot deposit the polysilicon channel 120 of 2 nm or less. Reducing the thickness through a dry etching process after depositing a thick polysilicon channel may degrade the roughness of the surfaces of the polysilicon channel 120 and the oxide semiconductor channel 110, making it impossible to improve the string current. Accordingly, the present invention may deposit the thin polysilicon channel 120 of 2 nm or less through the oxidation process and the selective solution etching process, and maintain the surface roughness of the polysilicon channel 120 and the oxide semiconductor channel 110 at a predetermined level.

In step S600, the oxide semiconductor channel 110 may be deposited by including at least one of indium oxide (In₂O₃) . zinc oxide (ZnO), gallium oxide (Ga₂O₃), indium zinc oxide (InZnO), zinc tin oxide (ZTO), and indium gallium zinc oxide (InGaZnO).

According to the present invention, it is possible to improve the mobility characteristics by using the oxide semiconductor channel.

In addition, according to the present invention, it is possible to implement the erase operation by including the polysilicon channel together with the oxide semiconductor channel.

In addition, according to the present invention, by forming the polysilicon channel of 2 nm or less, it is possible to distribute electrons on the oxide semiconductor channel in the on state in which the memory device operates.

In addition, according to the present invention, by depositing the polysilicon channel using the oxidation process and the selective wet etch process, it is possible to deposit excellent surface roughness on the polysilicon channel.

Although preferred embodiments of the present invention have been described above, the embodiments disclosed in the present invention are only for explaining, not limiting, the technical spirit of the present invention. Therefore, the technical idea of the present invention includes not only each disclosed embodiment but also a combination of the disclosed embodiments, and furthermore, the scope of the technical idea of the present invention is not limited by these embodiments. In addition, many modifications and alterations of the present disclosure may be made by those skilled in the art to which the present disclosure pertains without departing from the spirit and scope of the accompanying claims. In addition, it is to be considered that all of these modifications and alterations fall within the scope of the present disclosure.

## Claims

1. An oxide semiconductor memory device with dual channel structure, comprising:
a dual channel that includes a plurality of channels;
a tunnel layer that is located on the dual channel;
a charge trap layer that is located on the tunnel layer and traps an injected charge;
a blocking layer that is located on the charge trap layer; and
a gate electrode that is located on the blocking layer and applied with an on voltage and an off voltage from a gate bias circuit.

2. The oxide semiconductor memory device of claim 1, wherein the dual channel includes an oxide semiconductor channel and a polysilicon channel.

3. The oxide semiconductor memory device of claim 2, wherein the polysilicon channel of the dual channel is formed between the oxide semiconductor channel and the tunnel layer.

4. The oxide semiconductor memory device of claim 3, wherein the polysilicon channel has a thickness of 2 nm or less and 1 nm or more.

5. The oxide semiconductor memory device of claim 2, wherein the oxide semiconductor channel includes at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO).

6. A manufacturing method of an oxide semiconductor memory device with dual channel structure, comprising:
(a) alternately laminating a word line and an inter layer dielectric;
(b) forming a cylindrical hole in a center of the laminated word line and inter layer dielectric and forming a blocking layer on an inner circumferential surface of the hole;
(c) forming a charge trap layer on an inner circumferential surface of the blocking layer;
(d) forming a tunnel layer on an inner circumferential surface of the charge trap layer;
(e) forming a polysilicon channel on an inner circumferential surface of the tunnel layer;
(f) forming an oxide semiconductor channel on an inner circumferential surface of the polysilicon channel; and
(g) forming a gate electrode by removing the inter layer dielectric and depositing a metal along the word line.

7. The manufacturing method of claim 6, wherein in the step (e), the polysilicon channel is deposited using an oxidation process and a selective wet etch process.

8. The manufacturing method of claim 7, wherein the polysilicon channel has a thickness of 2 nm or less and 1 nm or more.

9. The manufacturing method of claim 6, wherein the oxide semiconductor channel includes at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO).
